# EUROPEAN PATENT APPLICATION

(11) **EP 4 776 324 A1**
(43) Date of publication of application: **15.07.2026**
(21) Application number: 25151492.3
(22) Date of filing: 13.01.2025
(51) Int. Cl.: H01J 37/04, H01J 37/09

(54) **POTENTIAL CORRECTOR UNIT, APPARATUS, AND METHOD OF USING THE POTENTIAL CORRECTOR UNIT**

(71) Applicant: ASML Netherlands B.V., 5500 AH Veldhoven (NL)
(72) Inventor: KRUPIN, Oleg, San Jose, CA 95134 (US); GONG, Zizhou, San Jose, CA 95134 (US); REN, Weiming, San Jose, CA 95134 (US); HU, Xuerang, San Jose, CA 95134 (US); VAN DER TOORN, Jan-Gerard, Cornelis, 5500 AH Veldhoven (NL); BAARS, Norman, Hendrikus, Rudolf, 5500 AH Veldhoven (NL); HEMPENIUS, Peter, Paul, 5500 AH Veldhoven (NL)
(74) Representative: ASML Netherlands B.V.

(57) **Abstract**

The present invention provides a potential corrector unit for use in a charged particle beam assessment apparatus 41 for assessing a sample 208. The potential corrector unit comprises a potential corrector 300 configured to influence an electric potential at a peripheral region of a surface of the sample. The potential corrector is disposed upbeam of the sample.

## Description

### FIELD

The embodiments provided herein generally relate to a potential corrector unit, an apparatus comprising the potential corrector unit, and a method of using the potential corrector unit.

### BACKGROUND

When manufacturing semiconductor integrated circuit (IC) chips, undesired pattern defects, as a consequence of, for example, optical effects and incidental particles, inevitably occur on a substrate (i.e. wafer or sample) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

In semiconductor chip manufacturing, to reduce the cost and increase the chip yield, typically only a small exclusion area at the edge of the wafer substrate (for example, less than 2 mm from the edge of the wafer substrate) is left unused. Correspondingly, it is desirable that the assessment systems be able to perform accurate surface measurements of all used wafer substrate areas, including the locations close to the periphery of the wafer substrate.

When scanning with the primary electron beam close to a periphery of the wafer, the landing position of the beam may experience a shift due to the abrupt variation of the electric potential at the wafer edge, leading to the distortion of the obtained surface image. To only a limited extent, this distortion may be compensated by a conductive surface disposed to surround the sample, at a different height and/or or at a different voltage to the sample. For example, a ring-shaped electrode may be disposed to circumferentially surround the sample.

For certain combinations of samples and sample support tables, the variation of the geometry is too large to compensate the distortion at regions of interest towards the periphery of the wafer. There is therefore a desire to improve accuracy and reliability of assessment towards a periphery of the wafer, and to therefore potentially increase a useful area of the wafer substrate.

### SUMMARY

It is an object of the present disclosure to provide embodiments of a potential corrector unit for use in a charged particle beam assessment apparatus for assessing a sample, an apparatus comprising potential corrector unit, and a method of using the potential corrector unit.

According to an aspect of the invention, there is provided a potential corrector unit for use in a charged particle beam assessment apparatus for assessing a sample. The potential corrector unit comprises a potential corrector configured to influence an electric potential at a peripheral region of a surface of the sample. The potential corrector is disposed upbeam of the sample.

According to another aspect of the invention, there is provided an assessment apparatus. The assessment apparatus comprises the potential corrector unit.

According to another aspect of the invention, there is provided a method of loading a sample into position on a sample support of a charged particle beam assessment apparatus comprising the potential corrector unit.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram illustrating a cross-sectional view of an exemplary arrangement of a sample support, objective and the electron beam of the prior art.
**FIG. 4A-B** are schematic diagrams illustrating an exemplary arrangement of a sample support, objective and the electron beam of the prior art, including a ring electrode, as viewed in cross-section and in plan view.
**FIG. 5A-E** are schematic diagrams illustrating possible arrangements of a potential corrector unit, as viewed in cross-section and in plan view.
**FIG. 6A-B** are schematic diagrams illustrating an arrangement including a potential corrector unit, as viewed in cross-section and in plan view.
**FIG. 7** is a schematic diagram illustrating a cross-sectional view of a charged particle device and a potential corrector supported on a sample support.
**FIG. 8A-D** is a series of schematic diagrams illustrating a process of loading a sample and potential corrector from a shelf onto the sample support.
**FIG. 9A-D** are schematic diagrams illustrating different potential corrector arrangements.
**FIG. 10** is a schematic diagram illustrating a partial cross-sectional view through a potential corrector unit including a conductive film.
**FIG. 11** is a schematic diagram illustrating cross-sectional view of a potential corrector connected to the charged particle device.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

Nowadays, progress in increasing the computing power of electronic devices and reducing the device size is accomplished by significantly increasing the packing density of circuit components, such as transistors, capacitors, diodes, etc., on an IC chip. This has been enabled by the fabrication of ever smaller structures forming individual elements and circuits. For example, an IC chip of a smart phone, which is the size of a thumbnail may include over several billion transistors. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer or sample) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

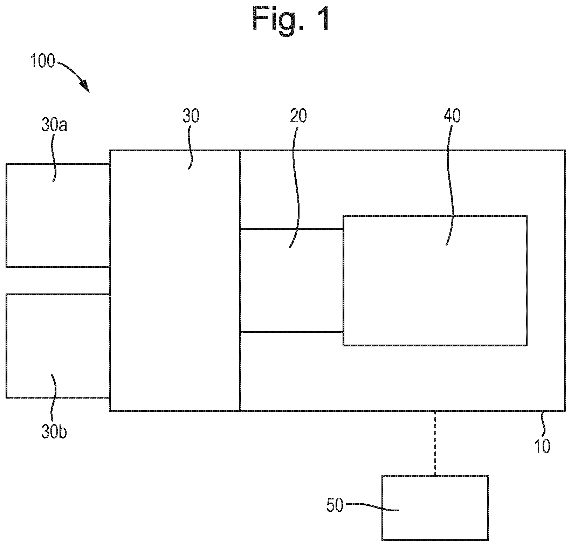

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

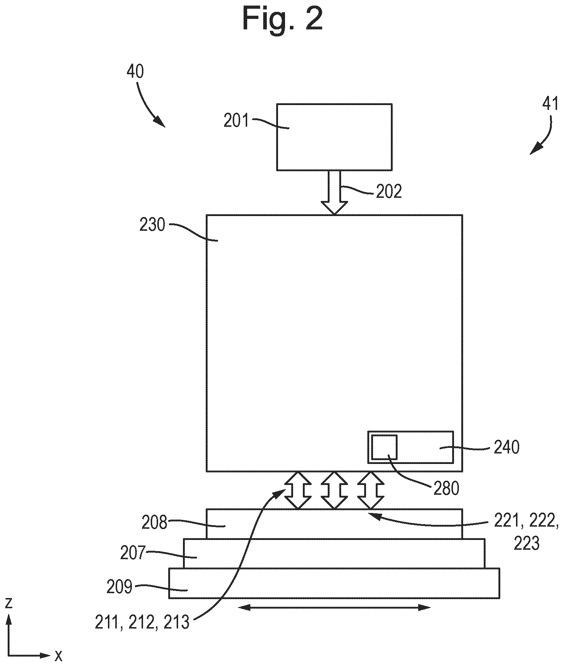

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The multi-beam charged particle device 41 of **FIG. 2** comprises an electron source 201 and a projection apparatus 230. The charged particle assessment system 40 further comprises an actuated stage 209 and a sample support 207. The sample support may have a holding surface (not depicted) for supporting and holding the sample. Thus the sample support may be configured to support the sample. Such a holding surface may be a electrostatic clamp operable to hold the sample during operation of the charged particle device 41 e.g. assessment such as measurement or inspection of at least part of the sample. The holding surface may be recessed into sample support, for example a surface of the sample support orientated to face the charged particle device 41. The electron source 201 and projection apparatus 230 may together be referred to as the charged particle device 41. The sample support 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

The sample may be held in place during inspection by a sample support. The sample support may be a sample support 207, such as that shown in **FIG. 2****.** The sample support 207 typically comprises a clamp to secure the sample 208 to the sample support 207.

To reduce the cost and increase the yield of each sample, typically only a small exclusion area at the edge of the sample (for example, less than 2mm from the edge of the sample) is left unused. Correspondingly, it is desirable that the assessment systems be able to perform accurate surface measurements of all used sample areas, including the locations close to the periphery of the sample.

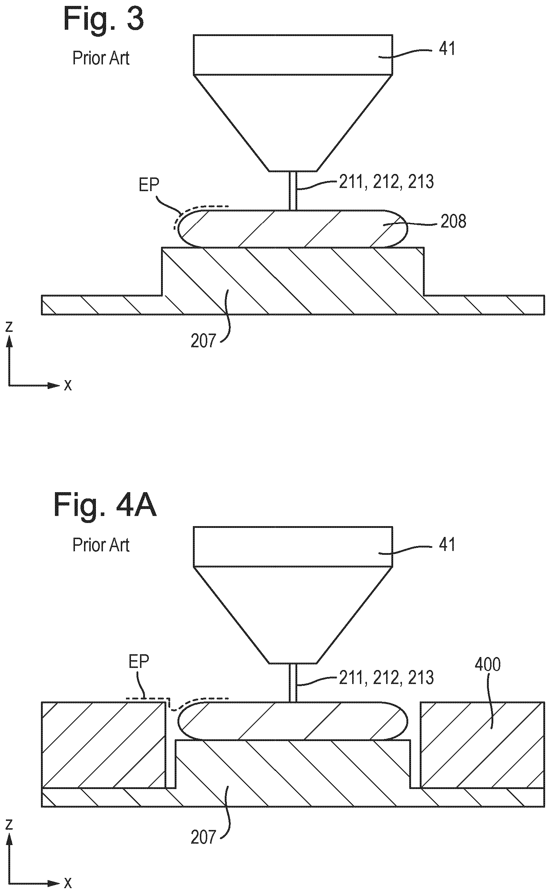

For the inner areas of the sample 208 (e.g., in a region near a radial center of the sample 208) the electric field experienced by the sub-beams 211, 212, 213 in the vicinity of the sample surface has nearly axial symmetry distribution around the optical axis. However, when inspecting the areas in the vicinity of the periphery of the sample 208 (e.g., in a region near to a peripheral edge of the sample 208), the electric field distribution experienced by the electrons may be distorted by considerable dipole deflection field due to an abrupt change of the potential at the peripheral edge sample 208. This problem is illustrated in FIG. 3, which depicts a sample 208 on a sample support 207. FIG. 3 illustrates how the electric potential (EP) varies at a periphery of the sample 208. The variation of electric potential distribution at the peripheral edge of the sample 208 can result in the deflection field affecting the sub-beams 211, 212, 213 in a peripheral region near the edge of the sample 208. As a result, the sub-beams 211, 212, 213 may undesirably shift with respect to the initially expected position on the sample. The shift can be significant enough to affects the accuracy and fidelity of measurements and inspections of sample surface topology in the peripheral regions of the sample 208.

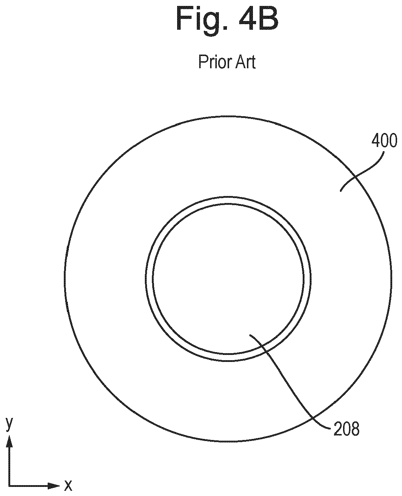

In arrangements of the prior art, such as depicted in FIG. 4A-B, a ring electrode 400 is typically positioned around the sample 208. FIG. 4A provides a cross-sectional view of the prior art arrangement, and FIG. 4B provides a plan view of the arrangement of FIG. 4A. As shown in FIG. 4A-B, the ring electrode 400 is disposed to surround the sample 208 such that the ring electrode 400 is positioned radially outward of the sample 208. The ring electrode 400 of FIG. 4A-B may aid in reducing the abrupt change in electric potential (EP) at the edge of the sample 208. Consequently, there may also be a reduction in charged-particle beam shift while scanning near the periphery of the sample 208, in comparison to the arrangement of FIG. 3 where the ring electrode 400 is not present.

In particular, in the arrangement of FIG. 4A-B, the ring electrode 400 is positioned around the sample 208 and is biased with compensating voltage with respect to the sample 208. In other words, a voltage of the ring electrode 400 may be different to a voltage of the sample 208 adjusted to minimize the beam shift in vicinity of the sample edge. The ring electrode 400 is located on the sample support 207 around a sample position, at which the sample 208 is disposed during inspection of the sample 208.

When a sample 208 is to be inspected, the sample 208 is positioned at the sample position on the sample support 207. For example, the sample 208 may be retrieved from a shelf by a robotic manipulator, or arm, and deposited at the sample position, with the ring electrode 400 located around the sample 208. In order to account for samples 208 having different diameters, and also for movement of the sample 208 to and from the sample position, an inner diameter of the ring electrode 400 should be greater than the outer diameter of the largest sample 208 to be accommodated. It is desirable that the inner diameter of the ring electrode 400 is large enough to provide a gap between the outermost edge of the sample 208 and the innermost edge of the ring electrode 400. For example, the gap size is preferably at least an order of several hundreds of microns. The potential variation associated with a gap of this size is still difficult to fully compensate using the electric potential of the ring electrode 400. Therefore, even with an arrangement such as that of FIG. 4A-B including a ring electrode 400, there remains a problem that there can be a sizable electron beam shift in the vicinity of the edge of the sample 208.

To reduce the potential variation and the beam shift induced by the peripheral edge of the sample 208 (or by the gap between the sample 208 and the ring electrode 400 around the sample 208), it is desirable to obscure the peripheral edge of the sample 208 or close the gap, as seen from the charged particle beams of the charged particle device 41. This may be achieved by putting a potential corrector, e.g. a potential correcting electrode, at an upbeam side of the sample 208, instead of directly radially outward of the sample 208 (as was shown with the ring electrode 400 of Figure 4A-B). In this way, the peripheral edge of the sample 208 or the gap between the sample 208 and a radially outward structure, may be obscured such that these regions are not in view of the charged particle device 41 disposed upbeam of the sample 208.

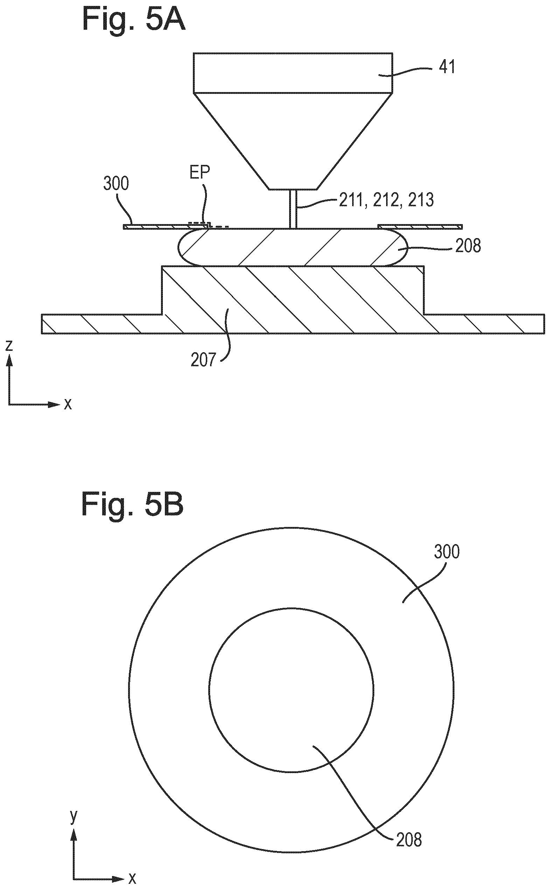

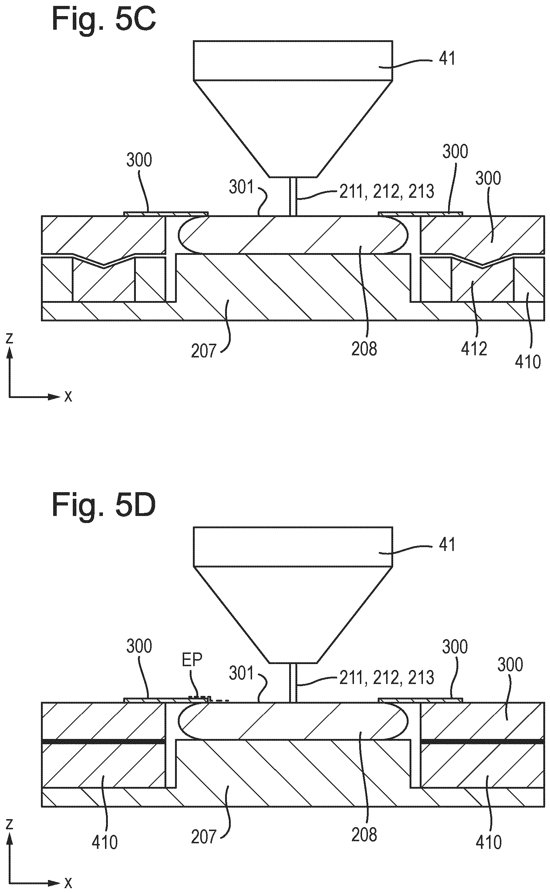

Example arrangements of a potential corrector 300 configured in this way are shown in FIGs 5A-E. FIG. 5A, 5C, and 5D and Fig. 1 1 each illustrate a cross-sectional view through a sample support 207 supporting a sample 208 with a potential corrector 300 disposed in a desired location over the sample 208. The charged particle device 41 directs charged particle beams 211, 212, 213 at the surface of the sample 208. An electrical potential EP towards the peripheral region of the sample 208 is shown to vary less than in the comparative arrangements of FIG. 3 and 4A. FIG. 5B illustrates a plan view of the potential corrector 300 of any of FIG. 5A, 5C and 5D in position over the sample 208.

In a preferred arrangement, as shown in FIGs 5A-E, the thickness of the potential corrector 300 and the vertical gap between the potential corrector 300 and the surface of the sample 208 should be as small as practically achievable in order to reduce the potential variation as much as possible. For example, the thickness of the potential corrector 300 may be less than or equal to 100 microns, preferably less than or equal to 10 microns, more preferably less than or equal to 1 micron, yet more preferably less than or equal to 0.1 micron, and yet more preferably less than or equal to 0.01 microns. A gap between the sample 208 and the potential corrector 300 (i.e., a gap in a Z direction of Fig. 5A), may be less than or equal to 100 microns, preferably less than or equal to 10 microns, more preferably less than or equal to 1 micron, yet more preferably less than or equal to 0.1 micron.

In some arrangements, the potential corrector 300 may be configured to touch a peripheral region of the sample 208. This touching of the sample 208 is acceptable in an exclusion area towards the peripheral edge of the sample 208 because the exclusion area is not used in the fabrication process). In another arrangement, the gap between the sample 208 and the potential corrector 300 (i.e., a gap in a Z direction of FIG 5A) remains because touching the sample 208 is not always desirable. Furthermore, due to factors including the thickness of the potential corrector 300 (which may be thicker than otherwise desirable in order to have sufficient structural rigidity) and the size of any gap between the sample 208 and the potential corrector 300 (in the Z-direction of FIG. 5A), the voltage applied to the potential corrector 300 may be set to be different from the voltage of the sample 208. Generally, the voltage of the potential corrector 300 may be set depending on the shape and thickness of the potential corrector 300, as well as on the size of the (vertical) gap between the sample 208 and the potential corrector 300.

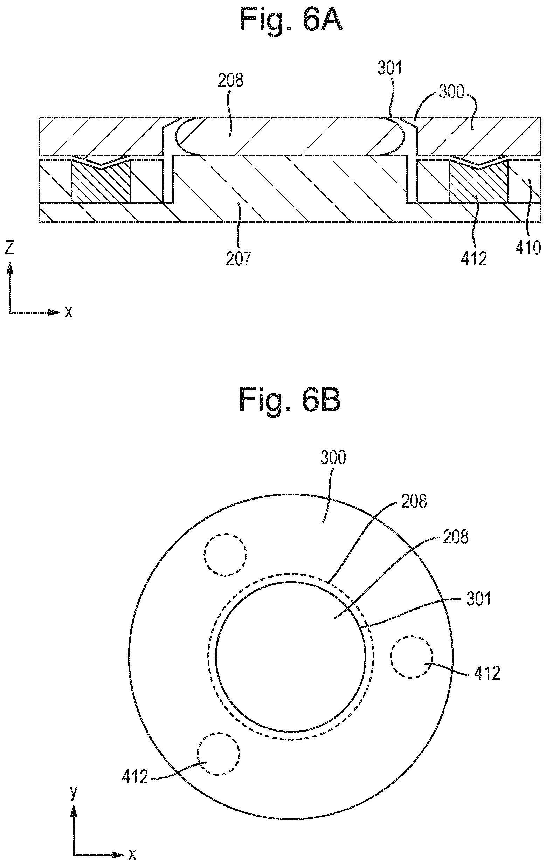

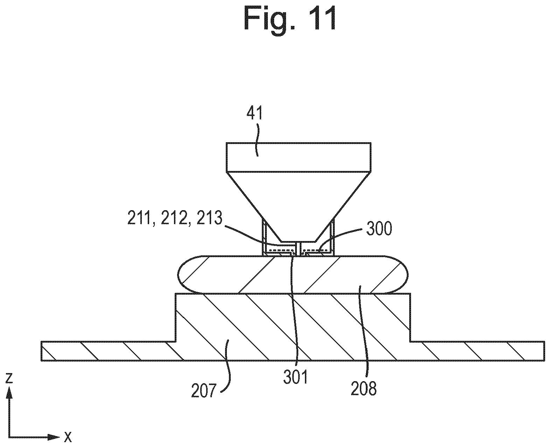

Some possible arrangements of the potential corrector 300, and possible ways mounting the potential corrector 300 in position relative to the sample 208 are illustrated in the examples of FIG. 5A-D and FIG. 11. These example arrangements are not intended to be considered limiting, alternative arrangements or combinations of these arrangements may be implemented, and further details regarding possible arrangements are also described, for example in reference to FIG. 6-10.

According to one arrangement, as shown in FIG. 5C, the potential corrector 300 can be implemented as detachable and removable from the sample support 207. Optionally, there may additionally be a support structure 410 disposed between the substrate support 207 and the potential corrector 300. The potential corrector 300 may be detachable from the support structure 410, such that the potential corrector 300 can be detached from the substrate support 207. Additionally, or alternatively, the potential corrector 300 may be connected (e.g., rigidly) to the support structure 410 and the support structure 410 may be detachable from the support structure, such that the potential corrector 300 can be detached from the support structure.

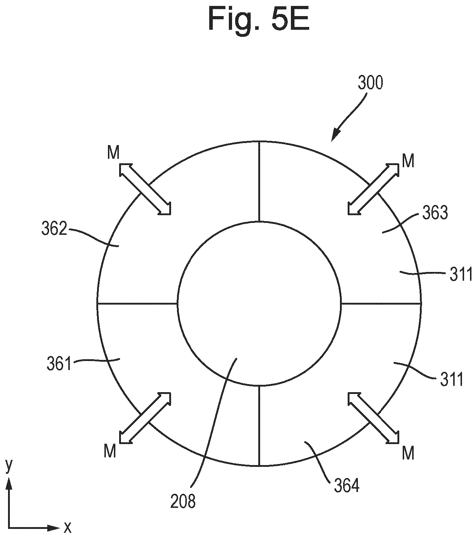

According to the arrangement shown in FIG. 5D-E, the potential corrector 300 is mounted on the sample support 207, for example via a support structure 410. In this arrangement, as shown in plan view in FIG. 5E, the potential corrector 300 is split into segments. Optionally, only one segment may be provided, with that segment of the potential corrector 300 being positioned upbeam (in a Z direction in FIG. 5E) of the sample 208 during use, such that the segment is configured to influence an electric potential at a peripheral region of a surface of the sample 208.

In a preferred arrangement, the one or more segments are configured to be movable (e.g., in a radial direction M as shown in FIG. 5E). In this way, the segments may be configured to move radially outward to enable changing the samples 208 on the sample support 207. The segments may be configured to move radially inward to set the potential corrector in position around and above the sample 208 for use during sample assessment. Optionally, the support structure 410 may also be split into corresponding moveable segments. This may enable easier access to deposit the sample 208 in the sample position on the sample support 207.

In an alternative arrangement, as shown in FIG. 11, the potential corrector 300 is mounted on the assessment system 40. For example, the potential corrector 300 may be connected to a component of the charged particle device 41, or to a part of the vacuum chamber itself.

Further details regarding possible implementations are described below. FIG. 6A-B shows an arrangement which includes a potential corrector unit. FIG. 6A shows a cross-sectional view through the potential corrector unit, the sample 208 and the sample support 207 on which the sample 208 is supported. FIG. 6B shows a plan view of the arrangement of FIG. 6A. The potential corrector unit is suitable for use in a charged particle beam assessment apparatus 100 for assessing a sample 208, such in the assessment system 40 of FIG. 1 and 2.

The potential corrector unit comprises a potential corrector 300 configured to influence an electric potential at a peripheral region of a surface of the sample 208. The potential corrector 300 is configured to influence an electric potential at a region on a surface of the sample 208 within a region including an outermost location on the sample 208 in a radial direction of the sample 208. The potential corrector 300 may be configured to be set at a different potential voltage than a potential voltage of the sample 208.

The potential corrector 300 may be configured to reduce a potential variation in a peripheral region of the sample 208. In particular, a potential variation may be reduced with the arrangement of FIG. 6A-B in comparison to the electrical potential (EP) variation in the arrangements of FIG. 3 and 4A-B. In other words, the potential corrector 300 is configured to reduce a change in electric potential at a periphery of the sample 208, compared to a change in electric potential at a periphery of the sample 208 in an arrangement not including the potential corrector 300. The potential corrector 300 is configured to reduce a charged particle beam 211, 212, 213 shift while scanning at the peripheral region of the surface of the sample 208, compared to a charged particle beam shift while scanning at the peripheral region of the surface of the sample in an arrangement not including the potential corrector. In this way, more accurate and reliable measurements may be determined in the peripheral region of the surface of the sample 208. This may result in improved fidelity of small-size defect detection and sample surface mapping in the peripheral regions of the sample 208. It may also benefit critical dimension (CD) measurements, where sub-nanometer accuracy and reproducibility of the measurements are required. It may also improve the matching between the measurements performed in the vicinity of the periphery of the sample 208 and measurements performed within the inner areas of the sample 208. The useful region of the sample 208 may include a region closer to an outermost edge of the sample 208 than would otherwise be practical, because this region can be more accurately measured when the potential corrector 300 is used. This may increase the yield from each sample 208.

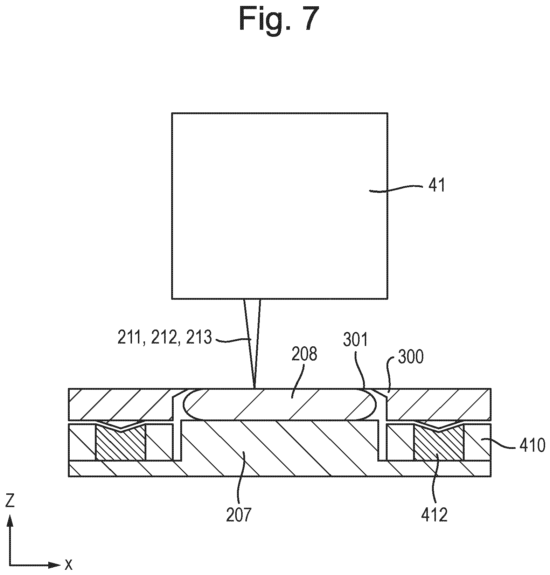

FIG. 7 shows the potential corrector unit of FIG. 6A-B in position for use within a charged particle beam apparatus 100. In particular, FIG. 7 shows the potential corrector 300 in position relative to the sample 208 and the charged particle device 41. As shown in FIG. 7, the potential corrector 300 defines an orifice 301 through which the charged particle beam may view the surface of the sample 208. The potential corrector 300 may therefore obscure a view of the surface of the sample 208 in regions radially outward of the orifice 301. The potential corrector 300 may limit influence of the sample surface potential on the charged particle beam to only the surface region defined by the orifice, while the potential corrector 300 is biased in the way to reduce beam shift. The potential corrector is configured to allow the one or more charged particle beams 211, 212, 213 of the charged particle device 41 to pass through the orifice 301 on a path to the sample 208 when the potential corrector 300 is disposed upbeam of the sample 208. In other words, in use, the potential corrector 300 defines an orifice 301 through which the single beam or plurality of sub-beams 211, 212, 213 pass on the path to the sample 208. In use, the potential corrector 300 is disposed such that the orifice 301 is defined to be level with or upbeam of the upper surface of the sample 208. The upper surface of the sample 208 being the surface of the sample 208 furthest in the upbeam direction, i.e., the surface scanned by the sub-beams 211, 212, 213 of the charged particle device 41. In other words, the potential corrector 300 surrounds a path of the sub-beams 211, 212, 213 at or upbeam of the upper surface of the sample 208.

The orifice 301 preferably has an opening size within a predetermined range of an outer diameter of the sample 208. As shown in FIG. 6A, the orifice 301 has a size smaller than an outer diameter of the sample 208. With this arrangement, the potential corrector 301 is disposed upbeam of the sample 208. The innermost region of the potential corrector 301 overlaps an outermost region of the sample 208, as shown in FIG. 6B.

The potential corrector 300 may be formed on, or configured to be attached to a support structure (Figure 5D). The support structure is desirably arranged to support the potential corrector 300 at a desired height relative to the sample 208. The support structure may be a support ring 410 configured to surround the sample 208 on the sample support 207. The support ring 410 is desirably disposed on the sample support 207. The sample support 207 may comprise an actuated stage and the support ring 410 maybe disposed on the actuated stage.

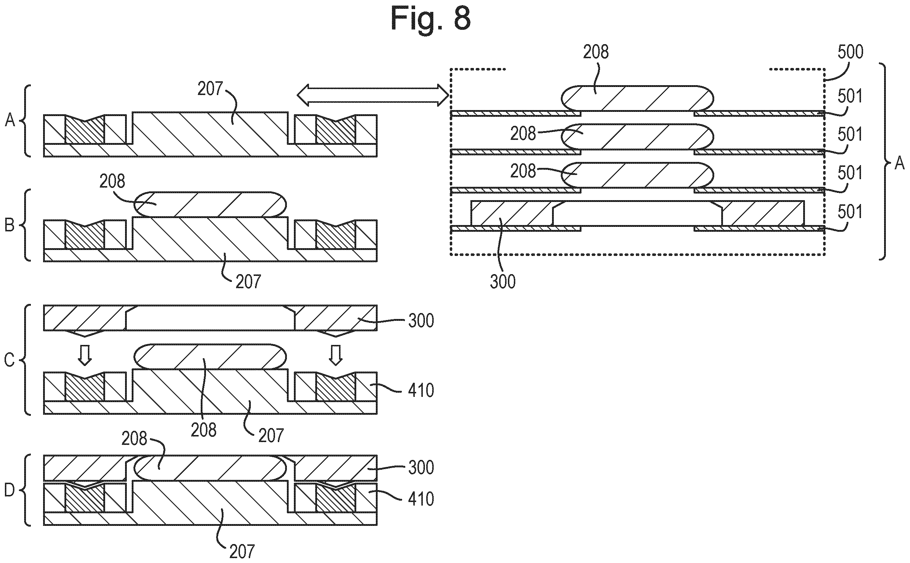

As shown in the arrangement of FIG. 8, the potential corrector unit may further comprise a shelf unit 500 comprising one or more shelves 501. The shelf unit 501 and the substrate support 207 may disposed within the same vacuum chamber, which may also house the charged particle device 41. Each shelf is desirably configured to support a one or more potential correctors 300 and/or one or more samples 208. The shelf unit 500 desirably comprises one or more shelves 501 to support a plurality of potential correctors 300. The potential corrector unit may comprise a plurality of potential correctors 300, supported by the shelf unit 500. The plurality of potential correctors 300 desirably includes potential correctors 300 having orifices 301 of different opening size. In this way, the potential corrector unit is configured to accommodate for samples 208 of different diameters. For example, there may be samples 208 of 200 mm and 300 mm in diameter. The potential correctors 300 may each have an orifice 301 with a diameter within a predetermined threshold of a diameter of a corresponding sample 208.

In some arrangements, the orifice 301 may have a opening size smaller than a diameter of the sample 208. In such an arrangement, the potential corrector 300 can be positioned above the sample 208 such that, as viewed in a plan view, the potential corrector 300 overlaps an unused region at the periphery of the sample 208. The potential corrector 300 can therefore influence the electric potential without obscuring a useful region of the sample 208.

The potential corrector 300 desirably defines an orifice 301 having an opening size within the predetermined threshold of the diameter of the corresponding sample 208. The orifice 301 may therefore have a diameter of less than, equal to, or slightly greater than the diameter of the corresponding sample 208. It may therefore not be possible to place a sample 208 at the sample position on the sample support 207 if the potential corrector 300 is in place over the sample position. As shown in FIG. 8A, a sample 208 may be retrieved, for example from the shelf unit 501, before the potential corrector 300 has been placed in position over the sample position. As shown in FIG. 8B, the sample 208 may then be placed on the sample support 207 in the sample position. As shown in FIG. 8C-D, the potential corrector 300 may then be retrieved, for example from the shelf unit 501, and placed in position over the sample 208. In this way, the sample 208 can be placed before the potential corrector 300 such that an opening size of the orifice 301 may be smaller than would be possible if the sample had to pass through the orifice 301 to be placed at the sample position on the sample support 207. The sample 208 may be unloaded from the sample support 207 by removing the potential corrector 300 and then removing the sample 208 from the sample support 207.

The sample 208 and/or the potential corrector 300 may be placed in position on the sample support 207 and/or retrieved from the sample support 207 and put back on a shelf 501 using an arm, for example a robotic arm. In one arrangement, the potential corrector unit may comprise an arm configured to retrieve one of the potential correctors 300 from the shelf 501. The arm may be configured to then deposit the potential corrector 300 in position over the sample 208. The shelf 501 is optionally configured to support the support ring 410 on which the potential corrector 300 is attached or formed. In this arrangement, the arm is desirably configured to retrieve a support ring 410, on which the potential corrector 300 is attached or formed, from the shelf 510, and deposit the support ring 410 in position to around the sample 208.

In order to increase throughput, and compensate for the time required to position the sample 208 and the potential corrector 300 on the sample support 207, the assessment system 100 may comprise a plurality of sample positions. The two sample positions may be provided on the same actuated stage or on different actuated stages. In this way, measurement of a sample 208 may be taking place at one sample position, and, simultaneously, a sample 208 and/or a potential corrector 300 may be being loaded/unloaded to/from another sample position. In this way, the throughput of samples 208 in the assessment apparatus 100 may be increased compared to an arrangement having only a single sample position.

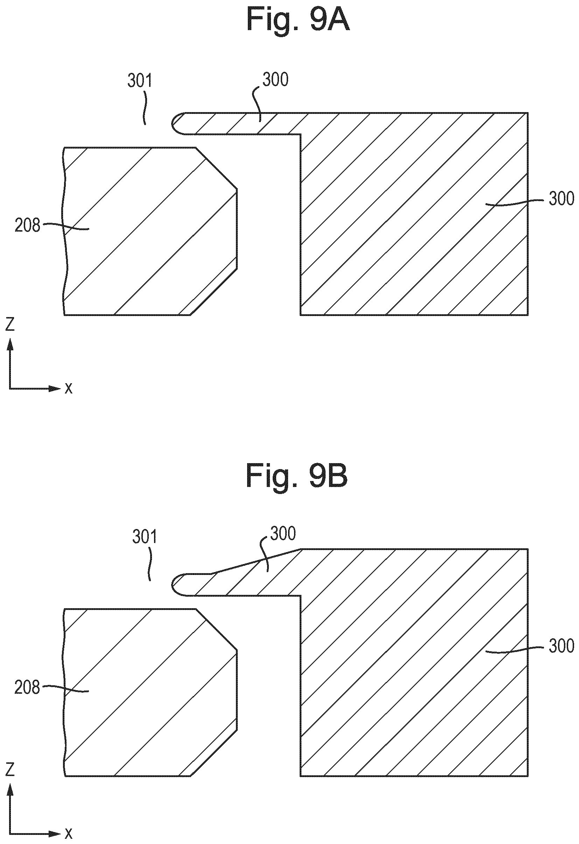

FIG. 9A shows a partial cross-sectional view of a potential corrector unit and a peripheral region of a sample 208 according to one arrangement. In the arrangement of FIG. 9A, an upper surface of the potential corrector 300 is substantially flat. In other words, the upper surface of the potential corrector 300 is level and a vertical distance between the upper surface of the potential corrector 300 and the upper surface of the sample 208 is constant. For example, the potential corrector 300 may have a constant thickness. The potential corrector 300 may be formed of a flat plate. This is a preferred arrangement, as it is a simple solution, which may have relatively low complexity of implementation and cost of manufacture.

FIG. 9B shows a partial cross-sectional view of a potential corrector unit and peripheral region of a sample 208 according to another arrangement. In the arrangement of FIG. 9B, a thickness of the potential corrector 300 increases with increasing distance radially outward (in a positive X-direction in FIG. 9B) from an innermost region of the potential corrector 300. In other words, a thickness of the potential corrector 300 in a region adjacent to the orifice 301 is less than a thickness of the potential corrector 300 at a more radially outward position. In this way, a small thickness may be achieved adjacent to the orifice 301, which may promote a desirable electric potential in this region, without compromising the overall structural rigidity of the potential corrector 300. In other words, the thicker regions of the potential corrector 300 may provide structural rigidity to reduce a likelihood of the potential corrector 300 sagging downwards towards the orifice 301. In the arrangement of FIG. 9B, a thickness of the potential corrector 300 changes gradually with changing radial distance from the orifice 301. In an alternative arrangement, there may be a stepped change in thickness of the potential corrector 300. In the arrangement of FIG. 9B, an upper surface of the potential corrector 300 changes in height with changing radial distance from the orifice 301 such that there is a change in thickness of the potential corrector 300. This is a preferred arrangement because the lower surface of the potential corrector 300 may be flat to reduce a risk of the potential corrector 300 impacting and damaging the sample 208. Nonetheless, according to an alternative arrangement, the change in thickness may be achieved by altering a height of the lower surface of the potential corrector 300 instead of, or as well as, changing a height of the upper surface of the potential corrector 300 in order to change the overall thickness of the potential corrector 300.

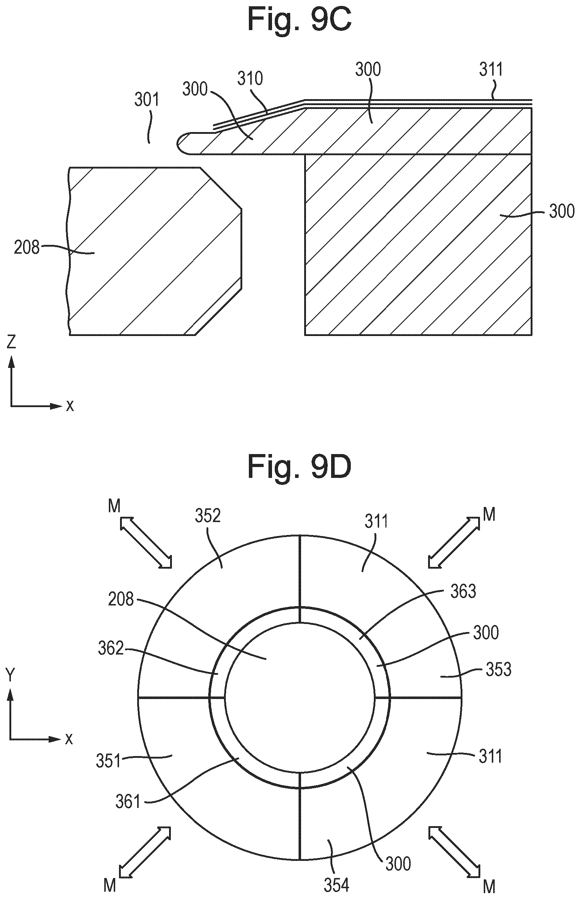

FIG. 9C shows a partial cross-sectional view of a potential corrector unit and peripheral region of a sample 208 according to another arrangement. In the arrangement of FIG. 9C, the potential corrector unit is the same as that of FIG. 9B, except that in FIG. 9C the potential corrector unit further comprises an electrical insulating layer 310 provided on the potential corrector 300. The electrical insulating layer 310 is preferably less electrically conductive than a main body of the potential corrector 300. In the arrangement of FIG. 9C, the electrical insulating layer 310 is provided on an upper surface of the potential corrector 300. In an alternative arrangement, the electrical insulating layer 310 may be provided on a lower surface of the potential corrector 300. The electrically insulating layer 310 may be provided on an upper and/or a lower surface of the potential corrector 300 of any arrangement, for example the arrangements shown in FIG. 9A and 9B.

As shown, for example, in FIG. 9C, the electrical insulating layer 310 is optionally provided in a region radially outward of the innermost region of the potential corrector 300. In other words, the potential corrector 300 does not include an electrical insulating layer 310 in the region of the potential corrector 300 adjacent to the orifice 301.

As shown, for example, in FIG. 9C, the potential corrector unit optionally further comprises an electrode layer 311 provided over the electrical insulating layer 310. The electrode layer 311 may partially or completely cover the electrical insulating layer 310, such that the electrical insulating layer 310 is between the electrode layer 311 and the main body of the potential corrector 300. In this way, the electrode layer 311 may be electrically isolated from the potential corrector 300. The electrode layer 311 is desirably configured to be set at a different potential voltage than a potential voltage of the potential corrector 300. In this way, a potential voltage may be different at different positions on the surface of the potential corrector unit. For example, in a region where the potential corrector 300 is bare, with no insulating or electrode layer, there may be a first potential voltage, whereas in another region, where the electrode layer 311 is present, there may be a second potential voltage different than the first potential voltage. In this way, the potential voltage at different regions of the potential corrector unit may be controlled as desired to achieve a desirable electrical potential in a peripheral region of the sample 208.

FIG. 9D shows a potential corrector unit, such as that of FIG. 9C, in the plan view. As shown, for example in the arrangement of FIG. 9D, the potential corrector 300 and/or the insulating layer 311 may comprise a plurality of sections 351-354, 361-364. The plurality of sections 351-354, 361-364 may be configured to have individually controllable voltage potentials. Alternatively, or additionally, the plurality of sections 351-354, 361-364 may be arranged in groups and each group may have individually controllable voltage potentials. This arrangement may beneficially provide flexibility in adapting a shape of the compensating-potential field of the potential corrector unit.

As shown, for example in the arrangement of FIG. 9D, the plurality of sections may comprise concentrically arranged sections. For example, one section 351-354 may be radially outward of another concentrically arranged section 361-364. The outermost concentrically arranged section 351-352 may correspond to the electrode layer 311. The innermost concentrically arranged section may correspond to the upper surface of the potential corrector 300.

As shown, for example in the arrangement of FIG. 9D, the plurality of sections may, in addition to or instead of comprising concentrically arranged sections, comprise radially arranged segments. For example, one segment 351, 361 may be concentrically adjacent to another radially arranged segment 352, 362.

As show, for example, in the arrangements of FIG. 5E and 9D, the potential corrector unit may comprise a plurality of sections that are configured to be individually actuated. For example, the plurality of sections 351-354, 361-364 may be concentrically and/or radially arranged, as in the arrangement of FIG. 9D. For example, each of the sections may be configured to move in a radial direction. The plurality of sections 351-354, 361-364 may be configured to be actuated to alter a shape and/or inner size of the potential corrector 300. In other words, a size or shape of the orifice 301 may be adjusted by moving one or more of the sections 351-354, 361-364. For example, one or more of the sections 351-354, 361-364 may be moved radially inwards or outwards, as shown by the arrows M of FIG. 9D. The plurality of sections 351-354, 361-364 may be configured to move such that the sample 208 may be loaded/unloaded to/from the sample position on the sample support 207. The plurality of sections 351-354, 361-364 may then be configured to be moved into position around and/or over the sample 208. The plurality of sections 351-354, 361-364 optionally are configured to be set at different potential voltages, as in the arrangement of FIG. 9D. Alternatively, the plurality of sections may be configured to be set at the same potential voltage. For example, the plurality of sections may be sections of the potential corrector 300 with or without any layers present on the surface thereof.

The potential corrector unit desirably further comprises a height actuator 412 configured to adjust a height of the potential corrector 300. In particular, the height actuator 412 may be configured to adjust a height of the uppermost surface of the potential corrector 300. In this way, the potential corrector 300 may be configured to accommodate samples 208 of different heights. Furthermore, the height of the potential corrector 300 may be adjusted in order to adjust the influence of the potential corrector 300 on the electric potential at the peripheral region of a surface of the sample 208.

The height actuator 412 may be configured to adjust a height of the potential corrector 300 by raising and/or lowering the support ring 410. In one arrangement, the height actuator may be disposed on or in the sample support 207. In another arrangement, the height actuator 412 may be disposed in or on the support ring 410 and configured to raise/lower the potential corrector 300. In another arrangement, the height actuator 412 may be disposed on or in the potential corrector 300. The height actuator 412 may be any suitable means to move change the height of the potential corrector 300. For example, the height actuator may comprise a piezoelectric actuator, a pneumatic actuator or a Lorentz actuator. In a preferred arrangement, the height actuator 412 comprises a piezoelectric actuator.

The potential corrector unit desirably further comprise a distance sensor configured to detect a distance between the potential corrector 300 and the sample 208. The distance sensor may be configured to measure a vertical distance between a lower surface of the potential corrector 300 over the upper surface of the sample 208. In this way, a situation where the potential corrector 300 impacts the sample 208 might be avoided and/or the potential corrector 300 may be positioned at a desired height above the sample 208.

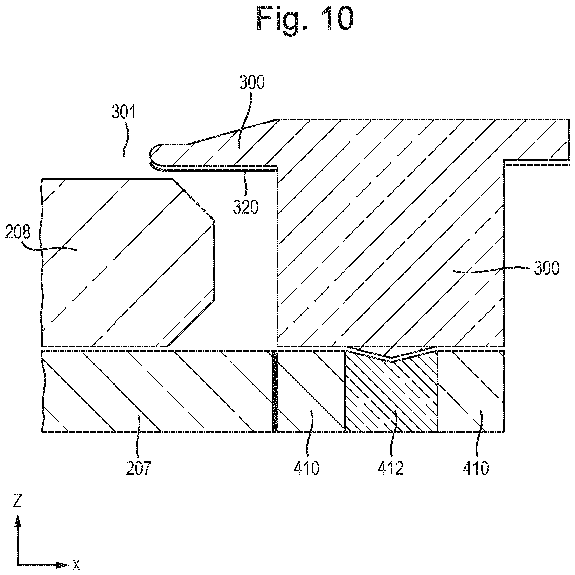

FIG. 10 illustrates a partial cross-sectional view through a potential corrector unit according to one arrangement. As shown in FIG. 10, the the potential corrector unit may comprise a conductive film 320. In the arrangement of FIG. 10, the conductive film 320 is disposed on a lower surface of the potential corrector 300. In particular, the conductive film 320 is disposed to face the upper surface of the sample 208. The conductive film 320 may be electrically isolated from a main body of the potential corrector 300. For example, an insulation layer may be provided between the conductive film 320 and the potential corrector 300. The conductive film 320 may, for example, be formed of or comprise metal. The conductive film 320 may be configured to be set at different potential voltage, as the potential corrector. For example, the conductive film 320 may be configured to be set at the same potential voltage as the sample 208, to protect the sample from the electric fields associated with the biased potential corrector.

The potential corrector unit of FIG. 10 optionally further comprises a contact sensor configured to detect contact between the conductive film 320 and the sample 208. In this arrangement, the conductive film 320 is desirably electrically isolated from the potential corrector 300.

The contact sensor may aid in avoiding a situation where the potential corrector 300 is lowered further after contacting the sample 208, which may aid in avoiding damage to the sample 208. Furthermore, the conductive film 320 may act as a barrier to reduce a likelihood of direct contact between the sample 208 and the potential corrector 300, therefore reducing a likelihood of damage to the sample 208.

The potential corrector unit, having a height actuator 412, is desirably configured to adjust a vertical position of the potential corrector 300 to increase and/or decrease a vertical distance between the lower surface of the potential corrector 300 and the upper surface of the sample 208. In one arrangement, the potential corrector unit is configured to adjust a vertical position of the potential corrector 300 based on measurement from the distance sensor. With an arrangement such as that shown in FIG. 10, the potential corrector unit is configured to adjust a vertical position of the potential corrector 300 based on measurement from the contact sensor instead of, or in addition to, being based on measurement from a distance sensor. Alternatively, or additionally, the potential corrector unit is configured to adjust a vertical position of the potential corrector 300 based on measurement from one or more optical elements of the charged particle device 41. For example, the detector 240 of the charged particle device 41 may be used to determine the height of the potential corrector 300. With these arrangements, the relative height of the potential corrector 300 over the sample 208 may be known and adjusted as desired to achieve a desirable electric potential across the sample 208.

In arrangements, for example that of FIG. 7 as described above, the potential corrector 300 is supported by the sample support 207, optionally via a support structure such as a support ring 410. An alternative arrangement is shown in FIG. 11 the potential corrector 300 is configured to connect to the charged particle device 41. In this arrangement, the potential corrector 300 can be realized as an electrode with a much smaller inner diameter than the diameter of the sample 208 . In other words, the orifice 301 may take the form of an aperture. The aperture is preferably placed directly upbeam of the surface of the sample 208. The diameter of the orifice 301 may be slightly larger than the electron beam size and scanning area on the sample 208. If the radius of the orifice 301 is less than the exclusion area at the sample edge (e.g., less than 2 mm), the orifice 301 does not allow the beam electrons to see any potential variation at the periphery of the sample 208 since it will be outside of the orifice 301 defining the area of the sample 208 seen by the electron beam.

In some arrangements, the potential corrector 300 is supported from below, on a downbeam side. In other arrangements, such as that of FIG. 11 the potential corrector 300 is supported from above, on an upbeam side. Another possible advantage of the potential corrector 300 being supported by the charged particle device 41, rather than the sample support 207, is that the potential corrector 300 does not need to be moved in order to load/unload the sample 208 to/from the sample position on the sample support 207.

In the arrangement of FIG. 7, the orifice 301 is arranged such that the potential corrector 300 is configured to surround a path of the beams of charged particles 211, 212, 213. In other words, the potential corrector 300 is arranged such that the paths of all sub-beams 211, 212, 213 generated by the charged particle device 41 pass through the orifice 301. In this way, the sub-beams 211, 212, 213 are not obstructed or obscured by the potential corrector 300. The opening size of the orifice 301 is desirably smaller than a diameter of the sample 208.

In a preferred arrangement, the potential corrector 300 is configured to connect to a component of the charged particle device 41 which is closest to the sample 208 during assessment of the sample 208. In other words, the potential corrector 300 may be configured to connect to a most downbeam component of the charged particle device 41.

The potential connector may be rigidly connected to the charged particle device. In another arrangement, the potential corrector unit may comprise a height actuator 412. The height actuator 412 may be configured to alter a distance between the charged particle device and a lower surface potential corrector 300. The height actuator 412 may therefore alter a distance between the upper surface of the sample 208 and the lower surface of the potential corrector 300.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. An actuatable component, such as a stage, may be controllable to actuate and thus move relative to other components such as the beam path using one or more controllers, control systems, or control units to control the actuation of the component.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one sub-device may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device.

Embodiments include the following numbered clauses:
1. A potential corrector unit for use in a charged particle beam assessment apparatus for assessing a sample,
   the potential corrector unit comprising a potential corrector configured to influence an electric potential at a peripheral region of a surface of the sample;
   wherein the potential corrector is disposed upbeam of the sample.
2. The potential corrector unit of clause 1, wherein the potential corrector defines an orifice configured to allow charged particle beams of the charged particle beam assessment apparatus to pass through the orifice on a path to the sample.
3. The potential corrector unit according to clause 2, wherein the orifice has an opening size within a predetermined range of an outer diameter of the sample.
4. The potential corrector unit according to clause 2 or 3, wherein the orifice has an opening size smaller than an outer diameter of the sample.
5. The potential corrector unit according to any preceding clause, wherein the potential corrector is configured to reduce a change in electric potential at a periphery of the sample, compared to a change in electric potential at a periphery of the sample in an arrangement not including the potential corrector.
6. The potential corrector unit according to any preceding clause, wherein the potential corrector is configured to reduce a charged particle beam shift while scanning at the peripheral region of a surface of the sample, compared to a charged particle beam shift while scanning at the peripheral region of the surface of the sample in an arrangement not including the potential corrector.
7. The potential corrector unit according to any preceding clause, wherein a thickness of the potential corrector increases with increasing distance radially outward from an innermost region of the potential corrector.
8. The potential corrector unit according to any preceding clause, further comprising an electrical insulating layer provided on the potential corrector.
9. The potential corrector unit according to clause 8, wherein the electrical insulating layer is provided on an upper surface and/or a lower surface of the potential corrector.
10. The potential corrector unit according to clause 8 or 9, wherein the electrical insulating layer is provided in a region radially outward of the innermost region of the potential corrector.
11. The potential corrector unit according to clause 9 or 10, wherein the electrical insulating layer is provided on an upper surface of the potential corrector, and the potential corrector unit further comprises an electrode layer is provided over the electrical insulating layer.
12. The potential corrector unit according to clause 11, wherein the electrode layer is configured to be set at a different potential voltage than a potential voltage of the potential corrector.
13. The potential corrector unit according to any of any preceding clause, wherein the potential corrector and/or the insulating layer comprises a plurality of sections.
14. The potential corrector unit according to clause 13, wherein the plurality of sections are configured to have individually controllable voltage potentials.
15. The potential corrector unit according clause 13 or 14, wherein the plurality of sections comprises concentrically arranged sections.
16. The potential corrector unit according to any of clauses 13 to 15, wherein the plurality of sections comprises radially arranged segments.
17. The potential corrector unit according to any of clauses 13 to 16, wherein the potential corrector comprises the plurality of sections, and the plurality of sections are configured to be individually actuated.
18. The potential corrector unit according to clause 17, wherein the plurality of sections are configured to be actuated to alter a shape and/or inner size of the potential corrector.
19. The potential corrector unit according to any preceding clause, further comprising a distance sensor configured to detect a distance between the potential corrector and the sample.
20. The potential corrector unit according to clause 19, wherein the distance sensor is configured to measure a vertical distance between a lower surface of the potential corrector over an upper surface of the sample.
21. The potential corrector unit according to any preceding clause, further comprising a conductive film disposed on a lower surface of the potential corrector.
22. The potential corrector unit according to clause 21, further comprising a contact sensor configured to detect contact between the conductive film and the sample.
23. The potential corrector unit according to any preceding clause, wherein the potential corrector unit is configured to adjust a vertical position of the potential corrector to increase and/or decrease a vertical distance between a lower surface of the potential corrector and an upper surface of the sample.
24. The potential corrector unit according to clause 23, when dependent on any of clauses 19 to 22, wherein the potential corrector unit is configured to adjust a vertical position of the potential corrector based on measurement from the distance sensor and/or the contact sensor.
25. The potential corrector unit according to clause 23 or 24, wherein the potential corrector unit is configured to adjust a vertical position of the potential corrector based on measurement from one or more optical elements of the charged particle beam assessment apparatus.
26. The potential corrector unit according to any preceding clause, wherein the potential corrector is formed on, or configured to be attached to, a support ring configured to surround the sample on a sample support.
27. The potential corrector unit according to clause 26, further comprising a height actuator configured to adjust a height of the potential corrector.
28. The potential corrector unit according to clause 27, wherein the height actuator is configured to adjust a height of the potential corrector by raising and/or lowering the support ring.
29. The potential corrector unit according to any of clauses 26 to 28, further comprising a shelf configured to support a plurality of potential correctors.
30. The potential corrector unit according to clause 29, further comprising the plurality of potential correctors, wherein the potential correctors have orifices of different sizes.
31. The potential corrector unit according to clause 29 or 30, further comprising an arm configured to retrieve one of the potential correctors from the shelf, and deposit the potential corrector in position over the sample.
32. The potential corrector unit according to any of clauses 29 to 31, wherein the shelf is configured to support the support ring on which the potential corrector is attached or formed.
33. The potential corrector unit according to clause 32, when dependent on clause 31, wherein the arm is configured to retrieve a support ring, on which the potential corrector is attached or formed, from the shelf, and deposit the support ring in position to surround the sample.
34. The potential corrector unit according to any of clauses 1 to 25, wherein the charged particle beam assessment apparatus comprises a charged particle device configured to project beams of charged particles towards the sample;
   wherein the potential corrector is configured to connect to the charged particle device.
35. The potential corrector unit according to clause 34, wherein the potential corrector is configured to connect to a component of the charged particle device which is closest to the sample during assessment of the sample.
36. The potential corrector unit according to clauses 34 or 35, wherein the potential corrector is configured to move with the charged particle device.
37. The potential corrector unit according to any of clauses 34 to 36, wherein the potential connector is rigidly connected to the charged particle device.
38. The potential corrector unit according to any of clauses 34 to 36, wherein the potential corrector defines an orifice arranged such that the potential corrector is configured to surround a path of the beams of charged particles.
39. The potential corrector unit according to any of clauses 34 to 38, further comprising a height actuator configured to adjust a height of the potential corrector.
40. The potential corrector unit according to clause 27, 28 or 39, wherein the height actuator comprises a piezoelectric actuator.
41. The potential corrector unit according to any of clauses 34 to 40, further comprising a ring electrode configured to surround the sample on a sample support.
42. An assessment apparatus for inspecting the sample, comprising a potential corrector unit according to any of the preceding clauses.
43. An assessment apparatus for inspecting the sample, comprising
   a potential corrector unit according to any of clauses 24 to 33; and
   the sample support configured to support the sample.
44. The apparatus according to clause 43, wherein the support ring is disposed on the sample support.
45. The apparatus according to clause 44, wherein the sample support comprises an actuated stage and the support ring is disposed on the actuated stage.
46. The apparatus according to any of clauses 43 to 45, further comprising a charged particle device configured to project beams of charged particles on a path, through the orifice, towards the sample.
47. An assessment apparatus for inspecting the sample, comprising
   a potential corrector unit according to any of clauses 34 to 41;
   a sample support configured to support the sample; and
   the charged particle device configured to project beams of charged particles on a path, through the orifice, towards the sample.
48. A method of loading a sample into position on a sample support of a charged particle beam assessment apparatus comprising the potential corrector unit according to any of clauses 24 to 33.
49. The method of clause 48, comprising
   placing the sample on the sample support; and
   placing the potential corrector in position over the sample.
50. The method of clause 49, wherein the charged particle beam assessment apparatus comprises a shelf, wherein the shelf and the substrate support are disposed within a vacuum chamber, wherein the method comprises retrieving the potential corrector from a shelf, before placing the potential corrector in position.
51. The method of clause 50, further comprising retrieving the sample from the shelf, before placing the sample on the sample support.
52. The method of any of clauses 49 to 51, further comprising unloading a sample from the sample support by removing the potential corrector and then removing the sample from the sample support.
53. The method of any of clauses 49 to 52, wherein the sample and/or the potential corrector are placed using a robotic arm.

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A potential corrector unit for use in a charged particle beam assessment apparatus for assessing a sample,
the potential corrector unit comprising a potential corrector configured to influence an electric potential at a peripheral region of a surface of the sample;
wherein the potential corrector is disposed upbeam of the sample.

2. The potential corrector unit of claim 1, wherein the potential corrector defines an orifice configured to allow charged particle beams of the charged particle beam assessment apparatus to pass through the orifice on a path to the sample.

3. The potential corrector unit according to claim 2, wherein the orifice has an opening size within a predetermined range of an outer diameter of the sample.

4. The potential corrector unit according to claim 2 or 3, wherein the orifice has an opening size smaller than an outer diameter of the sample.

5. The potential corrector unit according to any preceding claim, wherein the potential corrector is configured to reduce a change in electric potential at a periphery of the sample, compared to a change in electric potential at a periphery of the sample in an arrangement not including the potential corrector.

6. The potential corrector unit according to any preceding claim, wherein the potential corrector is configured to reduce a charged particle beam shift while scanning at the peripheral region of a surface of the sample, compared to a charged particle beam shift while scanning at the peripheral region of the surface of the sample in an arrangement not including the potential corrector.

7. The potential corrector unit according to any preceding claim, wherein a thickness of the potential corrector increases with increasing distance radially outward from an innermost region of the potential corrector.

8. The potential corrector unit according to any preceding claim, further comprising an electrical insulating layer provided on the potential corrector.

9. The potential corrector unit according to any of any preceding claim, wherein the potential corrector and/or the insulating layer comprises a plurality of sections.

10. The potential corrector unit according to any preceding claim, further comprising a distance sensor configured to detect a distance between the potential corrector and the sample.

11. The potential corrector unit according to any preceding claim, wherein the potential corrector unit is configured to adjust a vertical position of the potential corrector to increase and/or decrease a vertical distance between a lower surface of the potential corrector and an upper surface of the sample.

12. The potential corrector unit according to any preceding claim, wherein the potential corrector is formed on, or configured to be attached to, a support ring configured to surround the sample on a sample support.

13. The potential corrector unit according to claim 12, further comprising a height actuator configured to adjust a height of the potential corrector.

14. The potential corrector unit according to any of claims 1 to 11, wherein the charged particle beam assessment apparatus comprises a charged particle device configured to project beams of charged particles towards the sample;
wherein the potential corrector is configured to connect to the charged particle device.

15. An assessment apparatus for inspecting the sample, comprising a potential corrector unit according to any of the preceding claims.
